# EUROPEAN PATENT APPLICATION

(11) **EP 4 545 233 A1**
(43) Date of publication of application: **30.04.2025**
(21) Application number: 24206680.1
(22) Date of filing: 15.10.2024
(51) Int. Cl.: B23K 3/06, H01L 23/00, B23K 26/34

(54) **LASER-ASSISTED DEPOSITION WITH BEAM-SHAPING**

(30) Priority: 20.10.2023 GB 202316084
(71) Applicant: ASMPT SMT Singapore Pte. Ltd., Singapore 768924 (SG)
(72) Inventor: Falcon, Tom, Yeovil BA229UT (GB); Pape, Simon, Yeovil BA201SE (GB)
(74) Representative: Emerson, Peter James

(57) **Abstract**

Laser-assisted deposition is improved by shaping the laser beam before it irradiates the deposition tape. In a first specific example the beam is shaped to irradiate a larger area of the deposition tape than is possible with an unshaped laser beam spot. Preferably this larger area corresponds to the smallest SMT-pad to be formed on the workpiece, other, larger SMT-pads can be formed by additively combining such deposits. In a second specific example, the beam is split into a plurality of sub-beams, each of which plurality can be used to form a bump or ball of deposition medium, to provide a greatly increased throughput for wafer-bumping applications. In all cases, the invention makes use of the fact that the energy provided by the laser source is greater than necessary to effect deposition, therefore the laser energy may be more economically used by distributing it about a greater irradiation area than the known unshaped laser beam spot.

## Description

This invention relates to a laser-assisted deposition apparatus, a method for forming features on a workpiece by depositing deposition medium from a tape onto the workpiece, and a method for performing wafer bumping to form bumps or balls of deposition medium in a regularly-pitched array onto a workpiece.

### Background and Prior Art

Laser-assisted deposition (LAD) is a developing technology for depositing viscous material, in particular solder paste, onto a workpiece or substrate, and may be considered as an alternative to conventional paste deposition technologies such as stencil or screen-printing (hereafter referred to as 'screen-printing' for convenience). For convenience, the following description shall refer exclusively to deposition of paste, however it is to be understood that other viscous materials may equally be deposited. LAD processes are characterised by the use of flexible tape which has paste applied to one side thereof. A laser is directed to irradiate an area of the opposite, i.e. uncoated, side of the tape, which causes a small volume of paste to be ejected from the coated side aligned with the irradiation area. The ejected paste volume may then land on the workpiece at an aligned target location. There are various benefits to such an approach in comparison to conventional screen-printing processes:
- since the quantity of paste ejected from the tape is controlled by use of a laser, the paste deposited may potentially be controlled more accurately, and in smaller quantities, than with screen-printing;
- it is more readily possible to deposit additional paste onto a previously-deposited target, meaning that the height of the paste deposit may be accurately controlled;
- different materials may be deposited onto the same target area; and
- material may be added to a previously-printed substrate, for example to make good any deficiencies arising from the printing process.

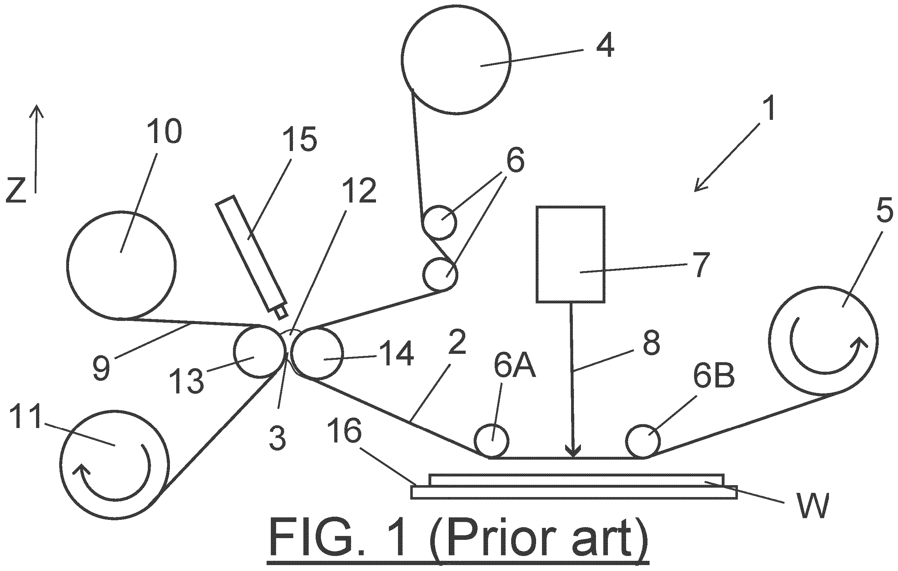

A typical LAD apparatus 1 is schematically shown, from the side, in FIG. 1, for use in depositing solder paste 3 from a deposition tape 2 onto a workpiece W. Typically, the deposition tape 2 is a flexible plastics material, such as for example, polyethylene naphthalate (PEN), polyethylene terephthalate (PET), polyimide (PI), or flexible glass, etc., or a composite of more than one such material, for example layered materials. The deposition tape 2, prior to coating with solder paste 3, may be stored on a deposition tape store reel 4. Prior to deposition, the deposition tape 2 is threaded to a used tape reel 5, which is rotatably driven to advance the deposition tape 2, so that driving of the used tape reel 5 causes the deposition tape 2 to unwind from the deposition tape store reel 4 and wind around the used tape reel 5. Various rollers 6 may be used to define the deposition tape path and provide tensioning of the deposition tape 2. In particular, two rollers 6A, 6B are used to maintain a region of the deposition tape 2 close to and parallel to the upper surface of the workpiece W. A laser source 7, which may comprise various types of laser source such as, for example, a Nd:YAG laser source, an Nd:YLF laser source, an Nd:YVO4 laser source, an Nd:GdVO4 laser source, a Yb:YAG laser source, an Er:YAG laser source, an Er:Cr:YSGG laser source, an Er:YSGG laser source and a Gd:WO4 laser source, is located above this region, aligned so as to produce a laser beam 8 which is directed to a spot on the upper surface of the deposition tape 2 between rollers 6A, 6B, i.e. at an 'illumination region' of the upper major surface of the deposition tape 2. The illuminating laser beam is transmitted through the deposition tape 2 to its underside. The workpiece W and the laser source 7 are relatively movable in the horizontal (XY) plane so that desired deposition patterns may be produced on the workpiece W. Typically the laser source 7 is drivable in the XY plane via a two-axis galvanometer arrangement (not shown), while the workpiece W is supported on a platform 16 which is held stationary. Alternatively the laser source 7 may be held stationary, while the workpiece W platform 16 is drivable in the XY plane via such a galvanometer arrangement. A further alternative is to drive both the laser source 7 and workpiece platform 16 in the XY plane to achieve the relative movement.

The underside of the deposition tape 2 is coated with solder paste 3 by using a coating tape 9 which is fed from a coating tape store reel 10 to a coating tape used reel 11, the coating tape used reel 11 being rotatably drivable to advance the coating tape 9. The coating tape 9 may comprise a flexible plastics material, and may advantageously be of a similar construction to the deposition tape 2, with the exception that the deposition tape 2 is provided with a hydrophilic surface and the coating tape with a hydrophobic surface. The coating tape 9 and deposition tape 2 are diverted to a paste application zone 12, formed between respective rollers 13, 14, at which there is a very small gap between the coating tape and the underside of the deposition tape 2. Solder paste 3 is released into the paste application zone 12 from a paste dispenser 15 so that a mass of solder paste 3 is formed between the rollers 13, 14. As the deposition tape 2 and coating tape 9 move past the paste application zone 12, the hydrophilic underside of the deposition tape 2 becomes coated with solder paste 3, with the thickness of the coating controlled by the distance between rollers 13, 14, with the hydrophobic surface of the coating tape 9 remaining substantially paste-free. It will be appreciated that the terms "hydrophobic" and "hydrophilic" properly apply to water-based fluids rather than flux-based fluids such as solder paste, but in practice solder paste exhibits similar wetting properties.

The laser beam which is transmitted through the deposition tape is absorbed by the paste 3 coated on the underside of the deposition tape 2, which causes paste to be ejected from the underside of the deposition tape 2 at the absorption location.

However, a problem exists with such known apparatus in that, since a laser is used to effect deposition, throughput is much lower than for screen-printing. Current LAD machines use a single point laser to eject deposition medium from the deposition tape to the workpiece. The throughput of the machine is then limited by the speed of the two-axis galvanometer and the X, Y axis platform 16 to which the workpiece W to be processed is mounted.

The present invention seeks to provide apparatus and methodology for significantly increasing throughput for LAD applications, in particular for SMT-pad deposition and for wafer-bumping applications, though it is envisaged that the present techniques will also have wider application, and potentially aid throughput in various applications.

In accordance with the present invention this aim is achieved by shaping the laser beam before it irradiates the deposition tape. In a first specific example the beam is shaped to irradiate a larger area of the deposition tape than is possible with an unshaped laser beam spot. Preferably this larger area corresponds to the smallest SMT-pad to be formed on the workpiece, other, larger SMT-pads can be formed by additively combining such deposits. In a second specific example, the beam is split into a plurality of sub-beams, each of which plurality can be used to form a bump or ball of deposition medium, to provide a greatly increased throughput for wafer-bumping applications. In all cases, the invention makes use of the fact that the energy provided by the laser source is greater than necessary to effect deposition, therefore the laser energy may be more economically used by distributing it about a greater irradiation area than the known unshaped laser beam spot.

As used herein, the term 'beam shaping' is used to refer to an optical process in which the laser beam energy is controllably distributed about a larger extent in a plane orthogonal to the optical path of the laser beam.

In particular, a beam shaper ideally suited for use with the present invention may be a diffractive optical element (DOE) or a spatial light modulator (SLM) such as an electrically-addressed spatial light modulator (EASLM), with each of these components being well-known per se so need not be described further here. However, DOEs function by diffracting incident light, while SLMs function by refracting incident light, and so these elements may also be termed 'diffractive / refractive beam shapers'.

### Summary of the Invention

In accordance with a first aspect of the present invention there is provided a laser-assisted deposition apparatus for depositing deposition medium from a tape onto a workpiece to form features thereon, the tape having upper and lower major surfaces, the lower major surface being coated with deposition medium, the laser-assisted deposition apparatus comprising:
a tape advancement mechanism for moving the tape through the laser-assisted deposition apparatus along a movement path,
a laser source operative to direct a laser beam along an optical path to the upper major surface of the tape at an illumination region thereof,
a workpiece support for supporting a workpiece proximate the lower major surface, such that deposition medium, located on the lower major surface thereof and in alignment with the illumination region, may be expelled from the lower major surface onto the workpiece when the laser beam is directed to the illumination region, and
a beam shaper positioned in the optical path to create an irradiation pattern at the illumination region.

In accordance with a second aspect of the present invention there is provided a method for forming features on a workpiece by depositing deposition medium from a tape onto the workpiece, comprising the steps:
i) providing a tape having upper and lower major surfaces, the lower major surface being coated with deposition medium,
ii) providing a laser-assisted deposition apparatus having a laser source ,
iii) supporting a workpiece proximate the lower major surface,
iv) advancing the tape through the laser-assisted deposition apparatus along a movement path, and
v) directing a laser beam from the laser source along an optical path to the upper major surface of the tape at an illumination region thereof such that deposition medium, located on the lower major surface thereof and in alignment with the illumination region, is expelled from the lower major surface onto the workpiece,
wherein step v) comprises shaping the laser beam to produce an irradiation pattern at the irradiation region.

In accordance with a third aspect of the present invention there is provided a method for performing wafer bumping to form bumps or balls of deposition medium in a regularly-pitched array onto a workpiece, comprising the steps:
i) providing a tape having upper and lower major surfaces, the lower major surface being coated with deposition medium,
ii) providing a laser-assisted deposition apparatus having a laser source,
iii) supporting a workpiece proximate the lower major surface,
iv) advancing the tape through the laser-assisted deposition apparatus along a movement path,
v) directing a laser beam from the laser source along an optical path to a beam shaper which splits the laser beam into a plurality of spatially separated sub-beams, and
vi) directing the plurality of spatially separated sub-beams to the upper major surface of the tape to form an illumination pattern at an illumination region thereof such that deposition medium, located on the lower major surface thereof and in alignment with the illumination pattern, is expelled from the lower major surface onto the workpiece.

Other specific aspects and features of the present invention are set out in the accompanying claims.

### Brief Description of the Drawings

The invention will now be described with reference to the accompanying drawings (not to scale), in which:
FIG. 1 schematically shows, from the side, a known laser-assisted deposition (LAD) apparatus;
FIG. 2 schematically shows, from the side, a laser-assisted deposition (LAD) apparatus in accordance with an embodiment of the present invention;
FIG. 3A schematically shows, from above, a workpiece with intended SMT-pad locations;
FIG. 3B schematically shows, from above, the workpiece of FIG. 3A with corresponding locations of laser beam spots illustrating the operation of a known LAD apparatus;
FIG. 3C schematically shows, from above, the workpiece of FIG. 3A with corresponding locations of laser beam patterns illustrating the operation of the LAD apparatus of FIG. 2;
FIG. 4 schematically shows, from above, a workpiece due to undergo a wafer-bumping process;
FIGs. 5A-C schematically show, from above, the workpiece of FIG. 4 during stages of a wafer-bumping process according to an embodiment of the present invention; and
FIGs. 6A, 6B schematically show, from above, the workpiece of FIG. 4 during stages of a wafer-bumping process according to another embodiment of the present invention.

### Detailed Description of the Preferred Embodiments of the Invention

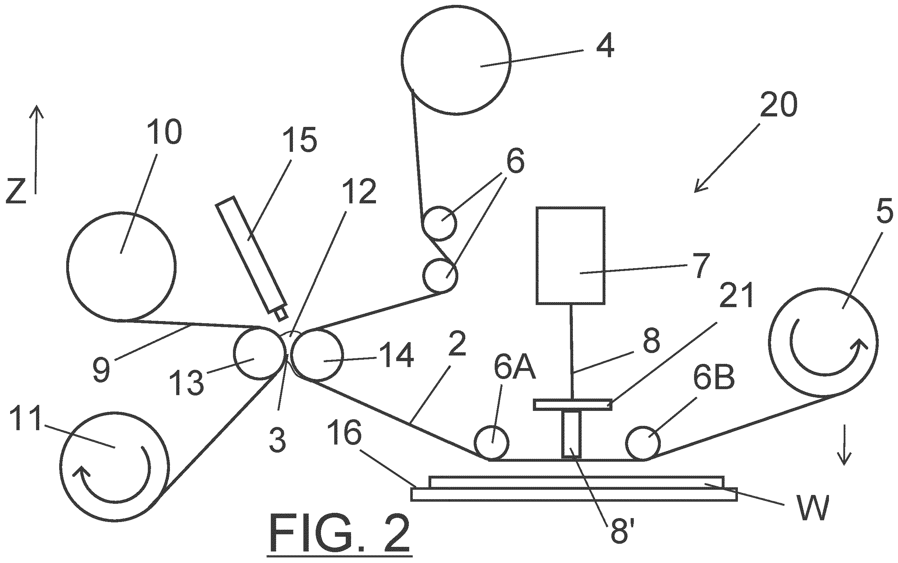

FIG. 2 schematically shows, from the side, a laser-assisted deposition (LAD) apparatus 20 in accordance with an embodiment of the present invention. The apparatus 20 clearly has many similarities with the known apparatus 1 of FIG. 1, with components common to both retaining the original numbering, and it is unnecessary to repeat description of all of those features here. Importantly however, the apparatus 20 includes a beam shaper 21 which is positioned in the optical path of the laser beam 8 emitted by laser source 7, before it reaches the deposition tape 2. The beam shaper 21 shapes the laser beam 8, so that a shaped laser beam 8' is produced, which irradiates the deposition tape 2. The shaped laser beam 8' creates an irradiation pattern, corresponding to a cross-sectional profile of the shaped laser beam 8', at the illumination region of the deposition tape 2. As noted previously, the beam shaper 21 is preferably a diffractive / refractive beam shaper, more preferably a DOE or SLM such as an EASLM. The beam shaper 21 may be held in place by any suitable mounting mechanism (not shown).

Various exemplary modes of operation for the apparatus 20 will now be described.

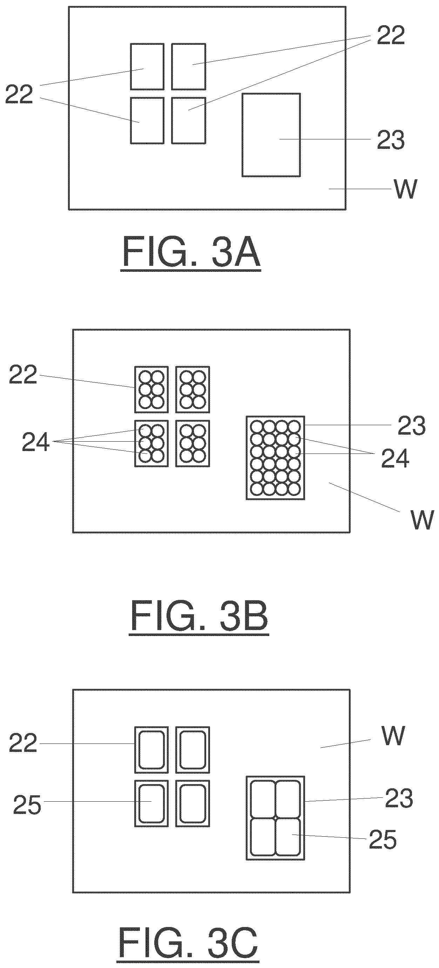

FIGs. 3A-C describe processes for forming features in the form of SMT-pads onto a workpiece W. FIG. 3A schematically shows, from above, a workpiece W with intended SMT-pad locations, including, for the sake of example only, four relatively small SMT-pad locations 22 and a relatively large SMT-pad location 23. To create the pads, LAD apparatus may be used to deposit deposition medium onto these locations.

FIG. 3B schematically shows, from above, the workpiece W of FIG. 3A with corresponding locations of 'spot deposits' 24 illustrating the operation of a known LAD apparatus 1. As shown, using the known LAD apparatus 1 of FIG. 1, each relatively small SMT-pad is formed by depositing six spot deposits 24 of deposition medium in a two-by-three matrix, while the relatively large SMT-pad is formed by depositing twenty-four such spot deposits 24 in a four-by-six matrix. Each individual spot deposit 24 is formed by irradiating the irradiation region of the deposition tape 2 with the unshaped beam 8, such that a very small amount of deposition medium is ejected from the deposition tape 2, so that a small 'spot deposit' 24 is formed. In total, using this known process, the workpiece W requires forty-eight spot deposits 24. Since only one spot deposit 24 may be formed at a time, this requires the workpiece W to be deposited on and then moved relative to the deposition tape 2 irradiation region ready for the next deposition forty-eight times. It should be understood that that the individual spot deposits 24 will coalesce and spread over the SMT-pad locations 22 and 23 during a subsequent reflow process.

FIG. 3C schematically shows, from above, the workpiece W of FIG. 3A with corresponding locations of laser beam patterns illustrating the operation of the LAD apparatus 20 of FIG. 2. Here, the beam shaper 21, such as a DOE, is used to create a shaped beam 8' which produces a substantially rectangular irradiation pattern, which has a shape and size which matches to an SMT-pad, advantageously, and as shown in FIG. 3C, to the smallest SMT-pad to be formed on the workpiece W. As such, the irradiation pattern is dimensioned to produce a shaped deposit 25 on the workpiece W, which substantially fills the relatively small SMT-pad location 22. The relatively large SMT-pad location 23 may be substantially filled by four shaped deposits 25 contiguously arranged in a two-by-two matrix. In total, using this exemplary process, the workpiece W requires eight shaped deposits 25. Since only one shaped deposit 25 may be formed at a time, this requires the workpiece W to be deposited on and then moved relative to the deposition tape 2 irradiation region ready for the next deposition eight times, which equates to a six-fold improvement in throughput compared to the known process described above. Again, it should be understood that that the individual shaped deposits 25 will coalesce and spread over the SMT-pad locations 22 and 23 during a subsequent reflow process.

Although the previous example described the formation of substantially rectangular SMT-pads, such methodology may equally be used to create other shaped SMT-pads, including, for the sake of example only, circular, triangular, square, arcuate, oval, obround or cruciform SMT-pads, or combinations thereof, such as so-called 'homeplate' or 'inverted homeplate' pads.

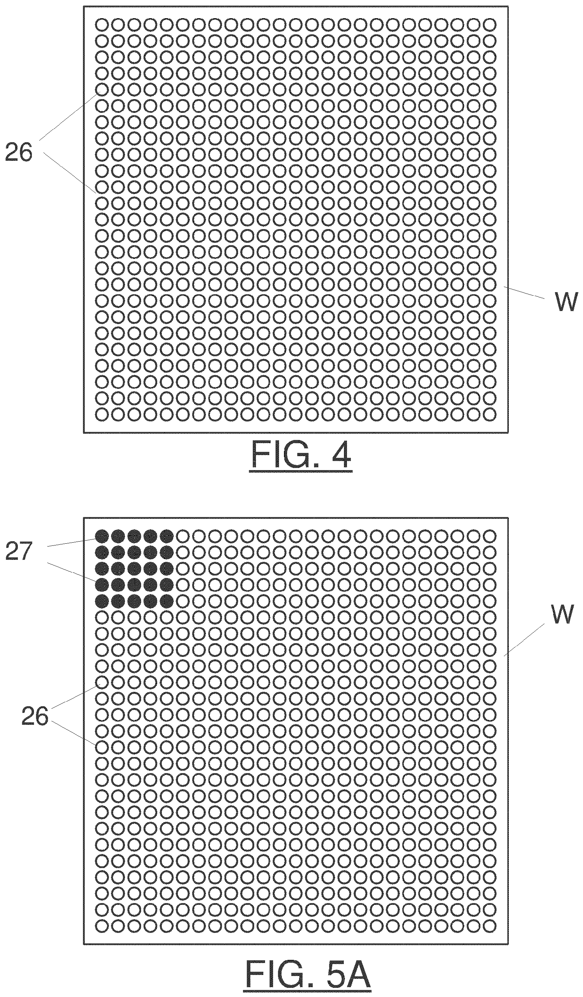

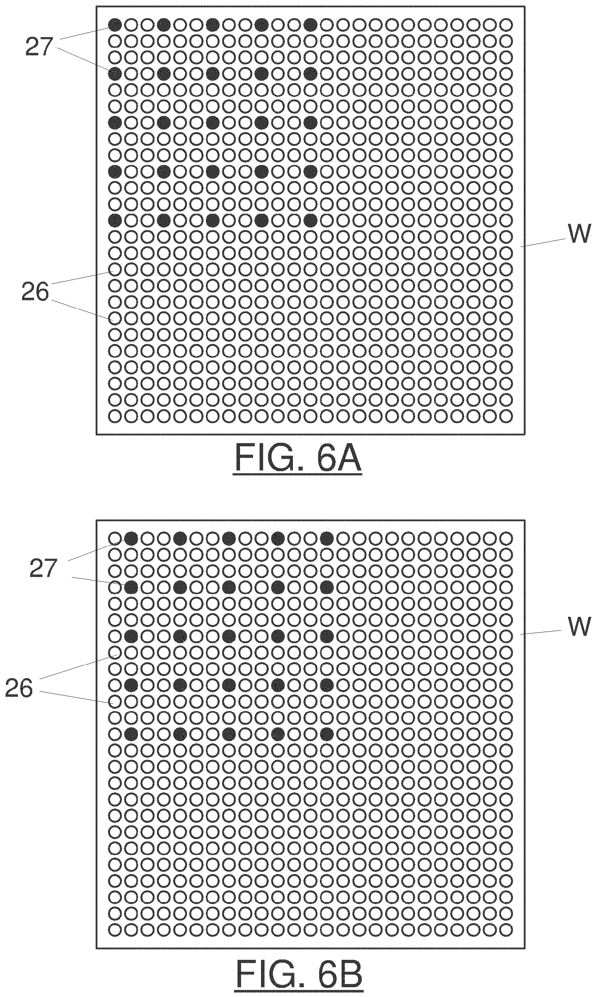

FIG. 4 schematically shows, from above, a workpiece W due to undergo a wafer-bumping process, and FIGs. 5A-C and 6A, B describe two different embodiments for performing such a wafer-bumping process. As shown in FIG. 4, a square workpiece W is shown having an array of six hundred and twenty-five ball locations 26, i.e. locations where bumps or balls of deposition medium are to be formed, in a twenty-five-by-twenty-five matrix array.

In a known wafer-bumping process, using known LAD apparatus 1 shown in FIG. 1, individual drops of paste are deposited by irradiating the irradiation region of the deposition tape 2 with the unshaped beam 8, such that a single drop of deposition medium is ejected from the deposition tape 2, and onto a ball location 26. Therefore, using this known process, the workpiece W must be deposited on and then moved relative to the deposition tape 2 ready for the next deposition six hundred and twenty-five times. Following such deposition, the workpiece W is subjected to a reflow process to form bumps or balls at each ball location 26.

In the following two embodiments, LAD apparatus 20 is used in which a beam splitter 21, for example an SLM or DOE, is used which acts to split the laser beam 8 into a plurality of spatially-separated sub-beams, in these instances into twenty-five sub-beams. For example, if the laser source 7 has a 25W output, each sub-beam may have 1W power, which is sufficient to eject a drop of deposition material from the deposition tape 2.

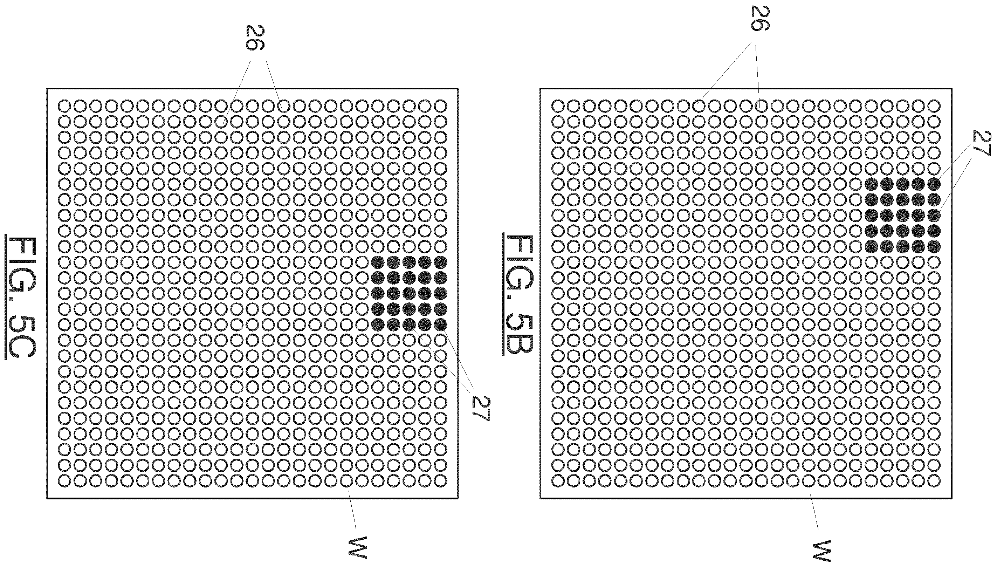

FIGs. 5A-C schematically show, from above, the workpiece W of FIG. 4 during stages of a wafer-bumping process according to one embodiment of the present invention, in which the twenty-five sub-beams are arranged adjacent to each other in a five-by-five matrix. As shown in FIG. 5A, in an initial step, the workpiece W is moved relative to the deposition tape 2 irradiation region so that the sub-beam matrix aligns with twenty-five ball locations in the upper-left area of the workpiece W as shown. Ball locations 26 filled in this position are shown in black at 27. Following deposition, the workpiece W is moved relative to the deposition tape 2 irradiation region so that an adjacent set of twenty-five ball locations 26 is aligned with the sub-beams, as shown in FIG. 5B. Once these ball locations 26 are filled, the workpiece W is again moved relative to the irradiation region, into the position shown in FIG. 5C, and twenty-five ball locations 26 are again filled. The process may repeat, for example in a rastering manner, until all ball locations 26 are filled with respective drops of deposition medium. Using this exemplary process, the workpiece W must be deposited on and then moved relative to the deposition tape 2 ready for the next deposition only twenty-five times, providing a twenty-five fold improvement in throughput compared with the known process described above. The workpiece may then be subjected to a reflow process to form bumps or balls in each filled ball location 26.

FIGs. 6A, 6B schematically show, from above, the workpiece of FIG. 4 during stages of a wafer-bumping process according to another embodiment of the present invention. This is similar to the embodiment described with reference to FIGs. 5A-C above, except that in this case, the plurality of sub-beams comprises a regular array of sub-beams in which the array of sub-beams has a pitch which is a multiple of the pitch of the ball array. As shown, the pitch of the sub-beam array has a pitch three times that of the ball array. Similarly to the embodiment described above, twenty-five ball locations 26 are filled in a single 'shot', followed by relative movement of the workpiece W and the irradiation region and filling of the next twenty-five ball locations 26. This embodiment is advantageous in that laser power is spread more widely across a correspondingly large irradiation region of the deposition tape 2, which reduces localised heating, and therefore possible distortion, of the deposition tape 2.

The above-described embodiments are exemplary only, and other possibilities and alternatives within the scope of the invention will be apparent to those skilled in the art. For example, The LAD apparatus may be provided with more than one beam shaper, each beam shaper being selectably movable into the optical path of the laser beam emitted from the laser source. Each beam shaper may be configured to shape the laser beam to a particular irradiation pattern as the application requires. This may be particularly advantageous if, for example, SMT-pads are required to be formed on a workpiece which have unusual shapes or dimensions.

Additionally or alternatively, where the laser beam is split by a beam-shaper, the shape and size of each sub-beam can be fully customised to suit the application; they do not necessarily need to have the same section.

### Reference numerals used:

1, 20 - LAD apparatus
2 - Deposition tape
3 - Solder paste
4 - Deposition tape store reel
5 - Used tape reel
6, 6A, 6B - Rollers
7 - Laser source
8 - Laser beam
8' - Shaped laser beam
9 - Coating tape
10 - Coating tape store reel
11 - Coating tape used reel
12 - Paste application zone
13, 14 - Rollers
15 - Paste dispenser
16 - Platform
21 - Beam shaper
22 - Small SMT-pad location
23 - Large SMT-pad location
24 - Spot deposits
25 - Shaped deposits
26 - Ball locations
27 - Balls undergoing deposition
W - Workpiece

## Claims

1. A laser-assisted deposition apparatus for depositing deposition medium from a tape onto a workpiece to form features thereon, the tape having upper and lower major surfaces, the lower major surface being coated with deposition medium, the laser-assisted deposition apparatus comprising:
a tape advancement mechanism for moving the tape through the laser-assisted deposition apparatus along a movement path,
a laser source operative to direct a laser beam along an optical path to the upper major surface of the tape at an illumination region thereof,
a workpiece support for supporting a workpiece proximate the lower major surface, such that deposition medium, located on the lower major surface thereof and in alignment with the illumination region, may be expelled from the lower major surface onto the workpiece when the laser beam is directed to the illumination region, and
a beam shaper positioned in the optical path to create an irradiation pattern at the illumination region.

2. The laser-assisted deposition apparatus of claim 1, wherein the features comprise SMT-pads, and the irradiation pattern has a size and shape which matches to an SMT-pad.

3. The laser-assisted deposition apparatus of claim 2, wherein the laser-assisted deposition apparatus is operative to form a plurality of SMT-pads on a workpiece, and the irradiation pattern matches the smallest SMT-pad of the plurality of SMT-pads.

4. The laser-assisted deposition apparatus of claim 1, wherein the beam shaper acts to split the laser beam into a plurality of spatially separated sub-beams.

5. The laser-assisted deposition apparatus of any preceding claim, wherein the beam shaper comprises a diffractive optical element.

6. The laser-assisted deposition apparatus of any of claims 1 to 4, wherein the beam shaper comprises a spatial light modulator.

7. A method for forming features on a workpiece by depositing deposition medium from a tape onto the workpiece, comprising the steps:
i) providing a tape having upper and lower major surfaces, the lower major surface being coated with deposition medium,
ii) providing a laser-assisted deposition apparatus having a laser source ,
iii) supporting a workpiece proximate the lower major surface,
iv) advancing the tape through the laser-assisted deposition apparatus along a movement path, and
v) directing a laser beam from the laser source along an optical path to the upper major surface of the tape at an illumination region thereof such that deposition medium, located on the lower major surface thereof and in alignment with the illumination region, is expelled from the lower major surface onto the workpiece,
wherein step v) comprises shaping the laser beam to produce an irradiation pattern at the irradiation region.

8. The method of claim 7, wherein the features comprise SMT pads, and the irradiation pattern has a size and shape which matches to an SMT pad.

9. The method of claim 8, for forming a plurality of SMT pads on a workpiece, and the irradiation pattern matches the smallest SMT pad of the plurality of SMT pads.

10. The method of claim 9, comprising forming larger SMT pads of the plurality of SMT pads by moving the irradiation pattern relative to the workpiece such that the larger SMT pads are formed from contiguous depositions of deposition medium which each match the irradiation pattern.

11. The method of any of claims 7 to 10, wherein step v) comprises passing the laser beam through a beam shaper.

12. A method for performing wafer bumping to form bumps or balls of deposition medium in a regularly-pitched array onto a workpiece, comprising the steps:
i) providing a tape having upper and lower major surfaces, the lower major surface being coated with deposition medium,
ii) providing a laser-assisted deposition apparatus having a laser source,
iii) supporting a workpiece proximate the lower major surface,
iv) advancing the tape through the laser-assisted deposition apparatus along a movement path,
v) directing a laser beam from the laser source along an optical path to a beam shaper which splits the laser beam into a plurality of spatially separated sub-beams, and
vi) directing the plurality of spatially separated sub-beams to the upper major surface of the tape to form an illumination pattern at an illumination region thereof such that deposition medium, located on the lower major surface thereof and in alignment with the illumination pattern, is expelled from the lower major surface onto the workpiece.

13. The method of claim 12, wherein the plurality of sub-beams comprises a regular array of sub-beams, the array of sub-beams having a pitch which is a multiple of the pitch of the array.

14. The method of any of claims 11 to 13, wherein the beam shaper comprises a diffractive optical element.

15. The method of any of claims 11 to 13, wherein the beam shaper comprises a spatial light modulator.
